# EUROPEAN PATENT APPLICATION

(11) **EP 4 709 092 A1**
(43) Date of publication of application: **11.03.2026**
(21) Application number: 24199205.6
(22) Date of filing: 09.09.2024
(51) Int. Cl.: H10D 89/60

(54) **ELECTRICAL PROTECTION CIRCUIT, INTEGRATED CIRCUIT, AND MOBILE COMMUNICATION DEVICE**

(71) Applicant: u-blox AG, 8800 Thalwil (CH)
(72) Inventor: Bonjour, Lysandre, 8800 Thalwil (CH)
(74) Representative: Epping - Hermann - Fischer

(57) **Abstract**

The present disclosure relates to an electrical protection, in particular an electrical clamp circuit (10, 50, 60, 80), comprising a protection device (16) electrically coupled between a supply voltage (VDD) input (12) and a reference potential (VSS) and having a control gate (22) for selectively activating a discharge path. The clamp circuit further comprises an RC circuit (26, 66) electrically coupled between the supply voltage (VDD) input (12) and the reference potential (VSS) and having a first internal node (24) for providing a control voltage, a first control path (18) electrically coupled between the first internal node (24) and the control gate (22) of the protection device (16) and having a first trigger element (32) for triggering the protection device (16), wherein the first trigger element (32) is configured to act as a digital control element, and a second control path (20) electrically coupled between the first internal node (24) and the control gate (22) of the protection device (16) and having a second trigger element (34) for triggering the protection device (16), wherein the second trigger element (34) is configured to act as a gradual control element.

The disclosure further relates to an integrated circuit (46) and a communication device (40) comprising an electrical protection circuit.

## Description

The present invention relates to an electrical protection circuit, in particular an electrical clamp circuit, comprising a protection device connected between a supply voltage input and a reference potential and having a control gate for selectively activating a discharge path. The present invention further relates to an integrated circuit comprising an electrical protection circuit and a mobile communication device comprising an integrated circuit.

Clamp circuits are used, for example, to protect other circuits and devices, such as system on a chip (SoC) devices against damages caused by certain external events.

Different types of clamp circuits, such as RC-NMOS voltage clamps, often simply called RC clamps, are known from the prior art. Such clamp circuits are designed to limit an input supply voltage to a safe operating area (SOA) corresponding to a maximum input voltage acceptable to a given electrical load connected to the supply voltage. Increases in a supply voltage may be triggered, for example, by so-called (unpowered) electrostatic discharge (ESD) events caused, for example, if the device is accidentally touched by an electrically charged body. For this purpose, so-called RC clamps are used to provide a discharge path between a supply voltage input and a reference potential.

However, the function of conventional clamp circuits is limited to protecting the circuit against damages caused by ESD discharge only. In particular, they may not be tuned to also react to other overvoltage (OV) conditions incurred during normal operation of a circuit, for example when an internal load is powered during normal operations by a supply voltage connected thereto. For example, when the input current of the internal load or another electrical load of the power supply suddenly changes, the supply voltage may start to ring, caused, for example, by a response of a DC/DC converter to the load changes. Similar effects can be caused by electromagnetic interference, due to electromagnetic coupling into a supply line. Moreover, power surges may also happen due to hot-plugging or network overload that can cause a power supply to increase above its maximum rating for a short period of time. In addition, powered ESD events may happen if a device is handled during operation. Such powered overvoltage conditions may lead to a latch-up in the circuit to be protected. Relatively small voltage changes encountered during operation may bring devices in the system out of their SOA. Such voltage changes may be smaller than relatively high voltage changes encountered during an ESD event. Accordingly, conventional clamp circuits may not react at all or at least not quick enough to OV events encountered during operation to protect the internal load reliably.

Accordingly, it is an object of the present disclosure to provide improved circuits and devices for protection of electrical circuits, such as SoCs, thereby further improving their electrical robustness and reliability, in particular during their operation, i.e. in a powered state.

The present disclosure provides an electrical protection circuit, in particular an electrical clamp circuit, comprising a protection device, an RC circuit, a first control path, and a second control path. The protection device is electrically coupled between a supply voltage input and a reference potential and has a control gate for selectively activating a discharge path. The RC circuit is electrically coupled between the supply voltage input and the reference potential and has a first internal node for providing a control voltage. The first control path is electrically coupled between the first internal node and the control gate of the protection device and has a first trigger element for triggering the protection device, wherein the first trigger element is configured to act as a digital control element, in particular as a switch. The second control path is electrically coupled between the first internal node and the control gate and has a second trigger element for triggering the protection device, wherein the second trigger element is configured to act as a gradual control element, in particular as a tunable current source or resistor.

Among others, the inventor has discovered that an electrical clamp or similar protection circuit can be further improved if different control paths are provided to deal with disturbances in a supply voltage of different magnitudes and/or speeds. In particular, by using a first control path comprising a first switching element configured to act as a digital control element, a discharge path can be rapidly activated in the case of a relatively high, rapid increase in the supply voltage, for example in the case of an ESD event. By using a second control path comprising a trigger element configured as a gradual control element, a more subtle control of the discharge path can be enabled, for example, in the case of a relatively small increase of a supply voltage during operation caused, for example, by a ringing of a DC/DC converter or another transient OV event.

Optionally, the first control path is configured to have a first output current response to transient voltages at the supply voltage input for triggering the protection device in the case of an unpowered OV event, in particular an ESD event, and the second control path is configured to have a second output current response to transient voltages at a supply voltage input for triggering the protection device in the case of a powered OV event.

For example, the first control path may either be fully switched off or fully switched on, effectively providing a digital control signal to the protection device. Such a response is particularly useful for protecting against ESD events by means of a high discharge current to rapidly route the charges accumulating on the supply terminal to the reference terminal, thus clamping the input supply voltage at a tolerable level according to SOA.

While such an output current response provides a high degree of protection against ESD events, it may require a relatively high supply voltage variation for the trigger element to be activated. Moreover, the protection device fully turns on and operates like a resistive switch leading to a rapid drop in the supply voltage. Accordingly, it may not be suitable for reacting to OV events encountered during normal operation of a circuit, e.g. in a powered state when a supply voltage is applied to a circuit to be protected. Among others, the inventor has found that a tolerable supply voltage variation before triggering may be lower for protection against powered OV events, and it may not be advisable to fully turn on the protection device as this could cause circuit brown-out or destruction of the protection device itself. Thus, the second control path is configured with a higher sensitivity and/or to provide a different output current response.

For example, if the supply voltage corresponds to an acceptable window around a nominal supply voltage, for example plus/minus 10 or 20% of a nominal supply voltage, the protection device is not triggered or is only triggered to such a minimum degree that it does not affect the operation of the circuit. However, under transient overstress, for example if a supply voltage increases by a fixed amount, such as 1 V, or beyond a given SOA window, the protection device is gradually operated into a conducting state corresponding to the deviation from the nominal voltage, to reduce the OV event to an acceptable degree. Note that in this case, the protection device may not be fully activated, to prevent a sudden drop in the supply voltage under a brown-out threshold voltage. Such over-compensation of the OV would cause a reset or chip malfunction.

Optionally, the first control path comprises at least one inverter for providing a digital control signal to a control gate of the first trigger element. By means of an inverter, an analog input signal can easily be converted into a digital control signal, thereby affecting the desired full activation of the protection device.

Optionally, the first trigger element is a first enhancement-mode field effect transistor (FET), in particular a first p-channel MOSFET, and the first control path comprises an even number of inverters electrically coupled in series between the first internal node and the control gate of the first FET. For example, two inverters may be directly connected in series to transform an analog input signal into a digital output signal of the same polarity for controlling the first control path. Based on such a digital input signal, an FET can be fully turned on to provide a required control signal to the protection device.

Optionally, the second control path is configured for providing an analog control signal to the second trigger element by tracking a difference between an instantaneous supply voltage provided at the supply voltage input and a filtered supply voltage provided by the RC circuit. Such an analog control signal can be used to control the protection device in accordance with a transient OV seen at a supply input.

Optionally, the second supply path is configured to stop triggering the protection device if a voltage difference between the supply voltage input and the first internal node drops below a predefined threshold voltage. In particular, voltage changes lying within a defined, acceptable window around a nominal supply voltage should not lead to a triggering of the protection device to avoid an unwanted and energetically wasteful activation of the protection device.

Optionally, the second trigger element is a second enhancement-mode FET, in particular a second p-channel MOSFET, and the first internal node is electrically directly connected to a gate of the second FET. In such a configuration, the second FET basically acts as a tunable current source for partially activating the protection device once a certain threshold voltage has been exceeded.

Optionally, the electrical protection circuit further comprises a discharge element electrically coupled to the control gate of the protection device for discharging the control gate of the protection device in case both the first control path and the second control path are disabled. For example, the discharge element may comprise at least one of a resistor or a FET with a dynamically driven gate. Such elements can be easily integrated into an electrical protection circuit to provide the desired functionality. Such a discharge element may be used to deactivate the protection device automatically once the triggering conditions are no longer met.

Optionally, a first time constant defined by the RC circuit is larger than a second time constant defined by the discharge element and a capacitive element associated with the protection device, in particular a parasitic capacitance of the control gate of the protection device. This ensures, amongst others, that the protection device can be switched off in time to avoid an undesirable drop in the supply voltage, in particular during normal operation of a circuit. This in turn helps to prevent a potential reset of, or damage to, an internal load.

Optionally, the electrical protection circuit further comprises a combinatorial element, in particular a logical OR-gate, a first input of the combinatorial element being electrically coupled to the first trigger element, a second input of the combinatorial element being electrically coupled to the second trigger element, and an output of the combinatorial element being electrically coupled to the control gate of the protection device. Note that in this case, both the essentially digital control signal provided by the first control path as well as the analog control signal provided by the second control path will be combined into a single, digital control signal driving the protection device. Nonetheless, the output current responses of the first and second control path can be designed to be different, thereby maintaining the desired different response characteristics of the protection device to different types of disturbances. In this case, the second path is designed to react fast enough to turn off the control signal at the protection device to avoid supply brown-out if the RC clamp triggers due to a powered OV event.

Optionally, the RC circuit comprises a resistive element electrically coupled between the supply voltage input and the first internal node, and a capacitive element electrically coupled between the first internal node and the reference voltage potential. For example, the resistive element comprises at least one of a resistor or a MOSFET, and/or the capacitive element comprises at least one of a capacitor or a MOSFET, which can be easily integrated into the electrical protection circuit. In such a configuration, the signal provided at the first internal node initially corresponds to a supply voltage prior to a disturbance and then slowly follows any changes in the supply voltage.

Alternatively, the RC circuit may comprise a capacitive element electrically coupled between the supply voltage input and the first internal node, and a resistive element electrically coupled between the first internal node and the reference voltage potential. In this configuration, the voltage provided by the internal node essentially follows the reference voltage.

In one specific embodiment of the above alternative, the electrical protection circuit is configured to invert a control signal provided by the first trigger element and/or the second trigger element before it is being provided to the control gate of the protection device. To activate the protection device as described before, the control signal is inverted.

Optionally, the electrical protection circuit further comprises a second internal node electrically coupled to the supply voltage input by means of one or more diodes, switches and/or current sources for providing a second supply voltage monitored by the RC circuit, wherein a supply voltage input of at least one of the first trigger element and the second trigger element is electrically coupled to the second supply voltage. Such a configuration is useful, for example, if some or all of the trigger elements and further components of the clamp circuit are designed to operate at a lower voltage than an external supply voltage provided to the electrical protection circuit.

The present disclosure further provides an integrated circuit (IC), in particular a system on a chip (SoC). The IC comprises a first voltage rail for providing a supply voltage, a second voltage rail for providing a reference voltage, an internal circuit configured to be supplied by the supply voltage, and an electrical protection circuit as detailed above. The electrical protection circuit is electrically coupled between the first voltage rail and the second voltage rail and configured to protect the internal circuit from both an unpowered OV event, in particular an ESD event, and a powered OV event.

The present disclosure further provides a mobile communication device, in particular a user equipment (UE) or global navigation satellite navigation (GNSS) device. The mobile communication device comprises an integrated circuit according to the second aspect, and a power supply circuit, in particular a DC/DC converter circuit, wherein output terminals of the power supply circuit are electrically coupled to the first voltage rail and the second voltage rail of the IC.

An IC and a mobile communication device as detailed above can be safely operated in various supply configurations and provide improved protection against a variety of disturbances in a supply voltage, including ESD and other OV events, both during operation of the IC and mobile communication device, i.e. in a powered state, as well as in a switched-off, unpowered or floating state. They help to improve their electrical robustness and operational reliability of the respective devices.

In the following, various embodiments of the disclosed circuits and devices are described in more detail. The embodiments are described with reference to the attached figures for better understanding, wherein the same or similar reference numerals are used for similar components of different embodiments. This does not mean, however, that these components are necessarily identical in each way.
Figure 1 shows a first clamp circuit.
Figures 2A and 2B show various currents and voltages in the first clamp circuit during an ESD event.
Figures 3A and 3B show various currents and voltages in the first clamp circuit during a transient, powered OV event.
Figure 4 shows a mobile communication device comprising an IC with a second clamp circuit.
Figure 5 shows a third clamp circuit.
Figure 6 shows a fourth clamp circuit.

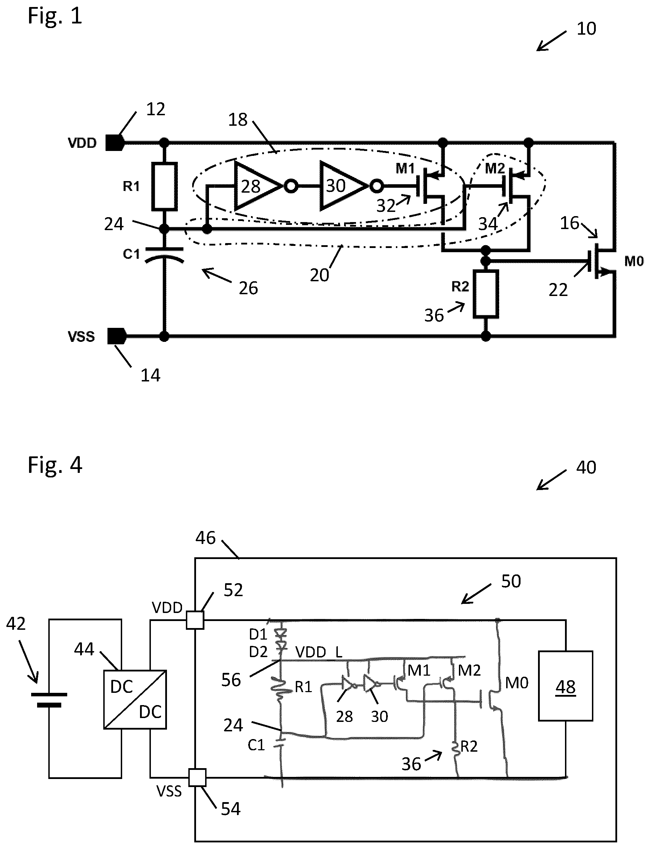

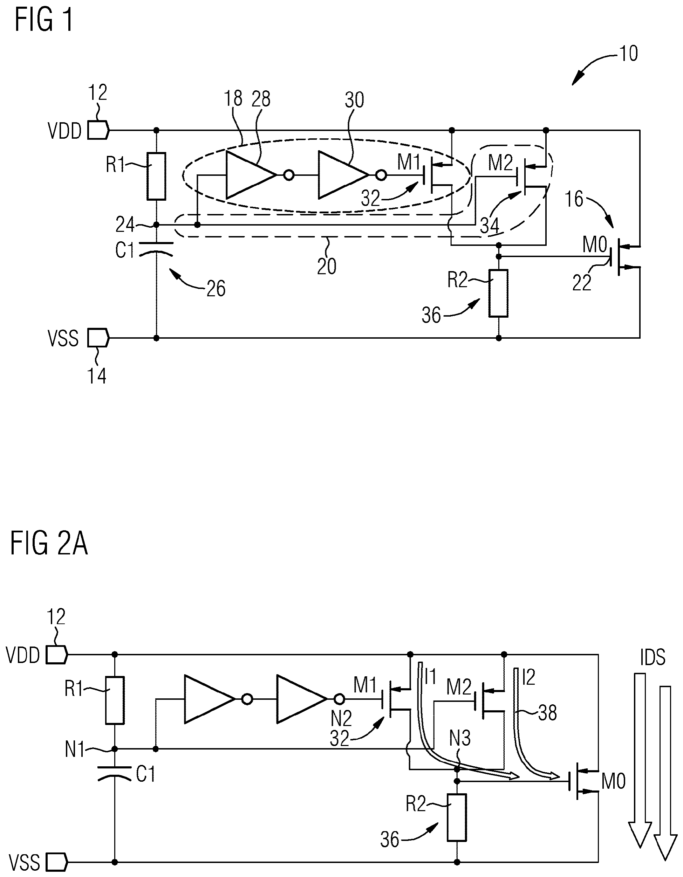

Figure 1 shows an electrical protection circuit in the form of a first clamp circuit 10. The clamp circuit 10 is connected to an input 12 for supplying a supply voltage VDD and a reference potential VSS provided at a reference node 14, such as electrical ground (GND). The clamp circuit 10 is designed to protect a load (not shown in Figure 1) from excessively high or low (negative) transients in the supply voltage VDD.

For this purpose, the clamp circuit 10 comprises a protection device 16. In the described embodiment, the protection device 16 is configured as a FET M0, referred to as a BigMOS FET because M0 is usually very large compared to most other FETs on a SoC. The source and the drain terminal of the protection device 16 are connected between the supply voltage VDD and the reference potential VSS and can be selectively closed by providing an appropriate signal to a control gate 22 of the protection device 16.

Triggering of the protection device 16 can be achieved by one of two different control paths 18 and 20, both connected to a first internal node 24 of an RC circuit 26 providing a control voltage to the control gate 22. The RC circuit 26 is also connected between the supply voltage VDD and the reference potential VSS. In the embodiment shown in Figure 1, a resistive element R1 is connected between the supply voltage VDD and the internal node 24, and a capacitive element C1 is connected between the first internal node 24 and the reference potential VSS. Accordingly, in a steady state, a voltage at the internal node 24 essentially corresponds to the supply voltage VDD. However, in case of transient voltages at the supply voltage VDD, the RC circuit 26 acts as a filter, in particular as a low pass filter, and provides a filtered version of the supply voltage VDD at the internal node 24 as input signal to the first control path 18 and the second control path 20. Although only a relatively simple RC circuit 26 forming a single filter is shown, multiple or different types of filters may be employed to generate one or more control voltages for the first control path 18 and/or the second control path 20.

The described first control path 18 comprises a first inverter 28, whose input is connected to the internal node 24, a second inverter 30, whose input is connected to the output of the first inverter 28, and a first trigger element 32 with a control gate, which is connected to the output of the second inverter 30. Note that in the described embodiment, the inverters 28 and 30 use the supply voltage VDD for operations. Assuming the inverter to be symmetrical, their switching voltage threshold is located at an input voltage of half of the difference between VDD and VSS. Consequently, as soon as the voltage at the first internal node 24 exceeds half of the supply voltage VDD at input 12, the first inverter 28 will output the supply voltage VDD at its output. Inversely, if the voltage at the first internal node 24 falls below half of the supply voltage VDD at input 12, the first inverter 28 will output the reference voltage VSS at its output. In either case, the second inverter 30 will flip too, providing the opposite output voltage. The switching voltage threshold may be designed to be different making the inverters more, or less sensitive to transient supply variations. Together, the first inverter 28 and the second inverter 30 essentially convert the analog input signal provided by the internal node 24 into a corresponding digital control signal for the first trigger element 32.

In the described embodiment, the first trigger element 32 is an p-channel MOSFET M1. As soon as the output of the second inverter 30 is flipped into a logical low state, the gate-source voltage difference switches the p-channel MOSFET M1 into an ON state. Inversely, if the output of the second inverter 30 is flipped into a logical high state, the source-gate voltage difference at the MOSFET M1 collapses, and it completely blocks any current therethrough. That means that the MOSFET M1 is operated like a switch, which switches an electrical path between the input 12 and the control gate 22 of the protection device 16 on and off, respectively.

The second control path 20 comprises only a second trigger element 34, whose control gate is connected directly to the first internal node 24. The second trigger element 34 is configured as an p-channel MOSFET M2. Accordingly, the voltage provided by the internal node 24 is used as an analog control signal to control a current through the second trigger element 34 in an essentially proportional fashion. Note that the drain and source terminals of the two trigger elements 32 and 34 are connected in parallel to provide respective trigger voltages to the protection device 16. Accordingly, activation of either one of the first control path 18 or the second control path 20 will activate the protection device 16.

The first clamp circuit 10 further comprises a discharge element 36 in the form of a resistor R2 connected between the control gate 22 of the protection device 16 and the reference potential VSS. The discharge element 36 pulls the voltage at the control gate 22 back to the reference potential VSS, thereby deactivating the protection device 16 in case the trigger conditions are no longer fulfilled.

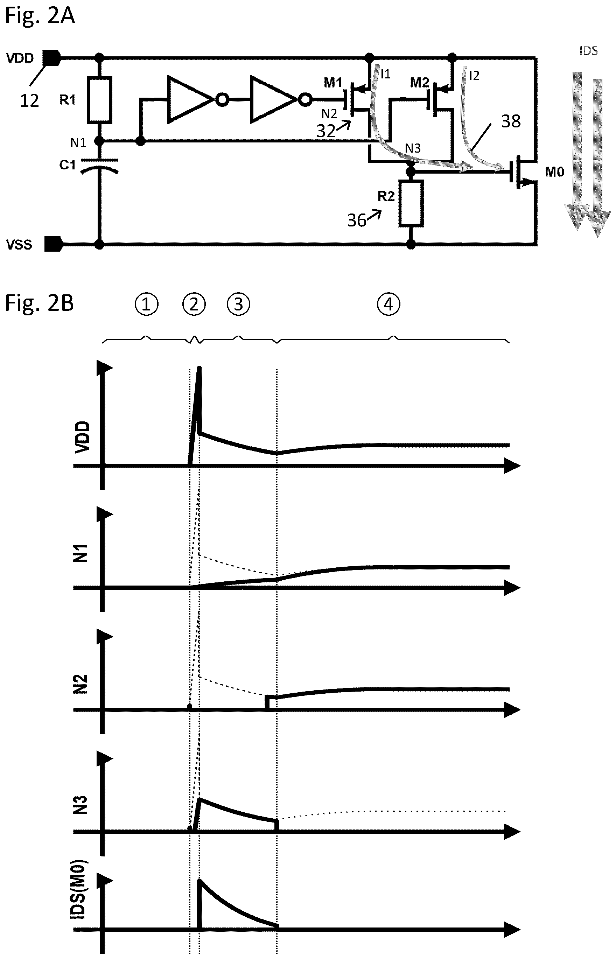

The operation of the first clamp circuit 10 is described in further detail below with respect to Figures 2A to 3B in different operating conditions.

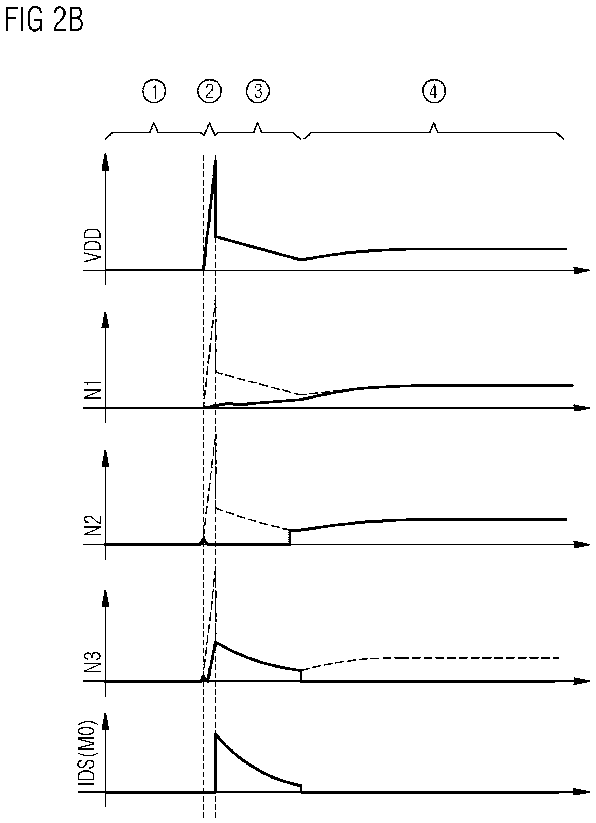

Figures 2A and 2B show various voltages and currents flowing through the first clamp circuit 10 during an ESD event. In the described scenario, a circuit comprising the first clamp circuit 10 is switched off. That is to say, the supply voltage VDD is initially zero. Then, electrical charges are injected rapidly on the VDD terminal 12 causing a relatively high, sharp voltage peak, endangering circuit components of the circuit to be protected. To avoid gate oxide, semiconductor junction breakdown or other physical damage, the first clamp circuit 10 needs to react quickly to sink the electrical charge associated with the ESD event.

As shown in Figure 2B, in a first phase ①, the supply voltage VDD corresponds to the reference voltage VSS. Accordingly, the supply voltage VDD, the voltage N1 at the first internal node 24, the voltage N2 at the control gate of the first trigger element 34 and the voltage N3 at the control gate 22 of the protection device 16 as well as the current IDS(MO) through the protection device 16 are also zero in initial phase ①.

In a second phase ②, electrical charges quickly accumulate at the input 12. As a consequence, the potential at VDD increases relatively rapidly. The shape of the supply voltage at the input 12 may correspond to an electrostatic discharge caused by a human body touching the input 12 of the circuit 10, or may correspond to a corresponding charge injection profile, for example based on human body model (HBM) testing. The voltage N1 at the internal node 24 slowly follows the increase in the supply voltage VDD as shown in Figure 2B.

At the end of the second phase ②, lasting typically less than 1 ns, the supply voltage is high enough for the circuit 10 to start operating, allowing the chains of inverters 28 and 30 to convert the analog voltage at N1 into a digital equivalent at N2 with VDD and VSS as references. This provides a corresponding control voltage for activation of the first trigger element 32. In particular, the gate of the p-channel MOSFET M1 will be pulled to VSS, while its source is connected to the supply voltage VDD. Note that the switching threshold of the invertors 28 and 30, e.g. half of the supply voltage VDD, impacts the overall switching delay. Choosing a very low threshold for the inverter 28 might seem a good idea for fast detection of an ESD event. However, this could also induce false triggering during a normal chip power-up. This could also cause the first control path 18 to turn on due to a negligible supply voltage disturbance.

Thus, at the beginning of a third phase ③, the first trigger element 32 is completely switched on, leading to a relatively large first control current I1 through the first trigger element 32. Note that in the third phase ③, the second trigger element 34 is also partially triggered by the voltage difference between the supply voltage VDD and the control voltage N1 at the first internal node 34. Accordingly, the second trigger element 34 also provides a second control current I2, which contributes to a trigger current for activating the protective device. However, due to the absence of any inverter circuits, the second control current I2 provided by the second control path 20 is smaller than the first control current I1 provided by the first control path 18 and can therefore be deemed negligible.

Due to the high control currents I1 and I2, the control voltage N3 at the control gate 22 of the protection device 16 quickly reaches a high voltage level, typical close to or at VDD voltage level, and the protection device 16 clamps the supply voltage VDD to the reference voltage VSS, thereby limiting the supply voltage VDD to a safe voltage level, as shown in Figure 2B. Note that during the third phase ③, the control voltage at the control gate 22 of the protection device 16 is sufficiently high to completely switch on the protection device 16.

Towards the end of the third phase ③, when the control voltage N1 at the first internal node 24 has been recharged to a level above a switching threshold, e.g., half of VDD at that instant, the chain of inverters 28 and 30 flips back, completely deactivating the first trigger element 32. As the control voltage N1 gradually increases, the current through the second trigger element 34 also slowly decreases and is eventually blocked off completely at the end of the third phase ③ or beginning of a fourth phase ④, such that the protection device 16 will be deactivated at the beginning of the fourth phase (4).

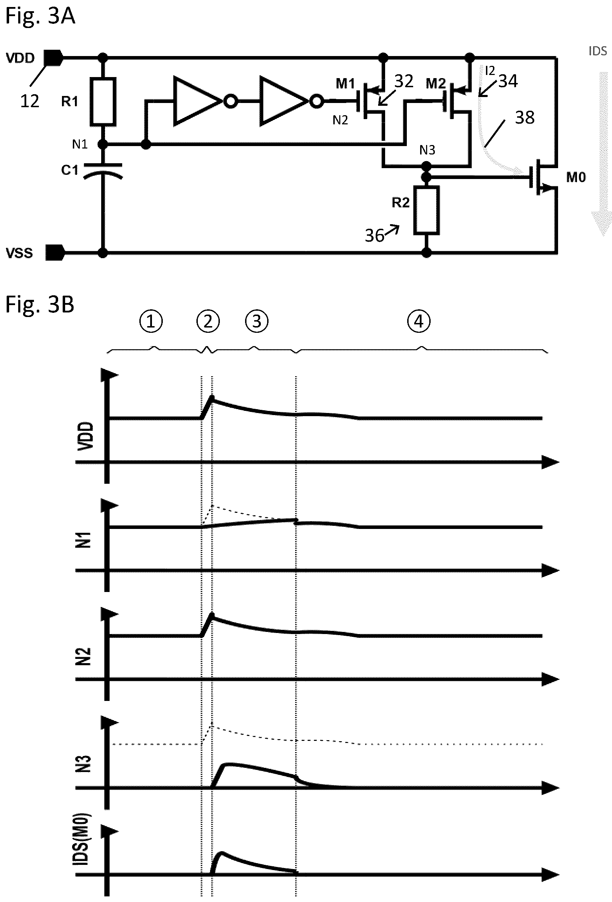

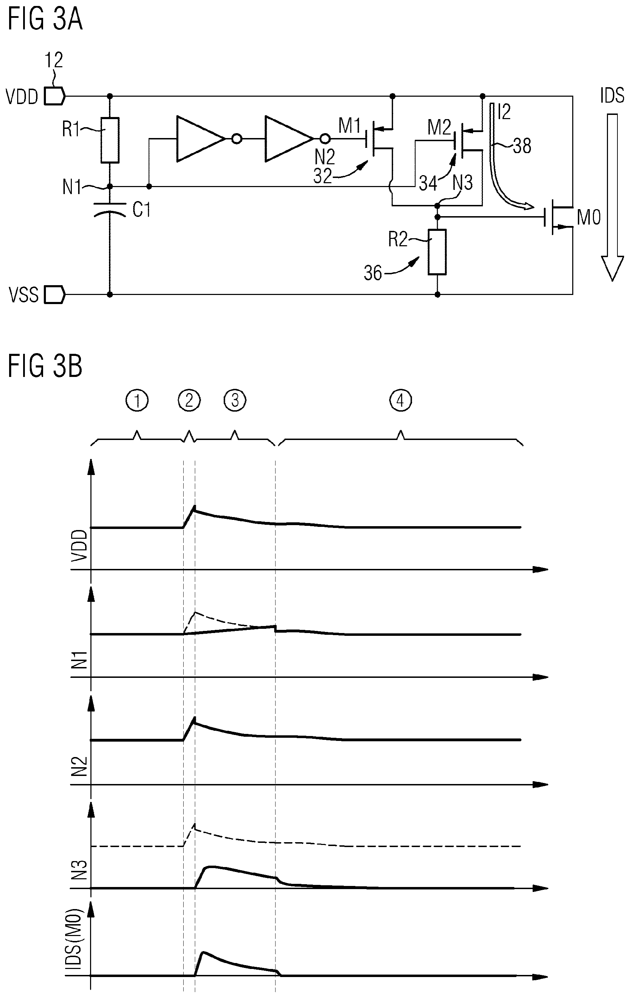

Figures 3A and 3B show the operation of the first clamp circuit 10 during a transient OV event while the chip is in powered state. Electrical devices usually remain safe under an absolute maximum supply voltage, which is a function of the time the stress is applied. Thus, in general, triggering of the protection device should depend on a shape of a waveform of an OV event. Note that for a given OV event, the chip may need to react to a smaller relative voltage increase in a powered state of the circuit to be protected, as compared to an unpowered state because the initial settled supply voltage is closer to the SOA limit when the device is powered.

In a first phase ①, the supply voltage VDD corresponds or is at least close to a nominal supply voltage of the load. In this situation, the voltage N1 at the first internal node 24 is also constant and essentially corresponds to the supply voltage VDD. Accordingly, voltage difference between the supply voltage VDD and the voltage N1 is practically zero, such that neither the first trigger element 32 nor the second trigger element 34 is triggered in this phase.

In a second phase ②, a sudden OV occurs at the supply voltage VDD. For example, due to a ringing of a DC/DC converter, the supply voltage VDD provided at the input 12 may increase by a couple of volts. In this phase, the supply voltage VDD increases until the difference of voltage between VDD 12 and the internal voltage 24 is large enough, and the propagation time of the trigger circuit is fulfilled for the control path 18 and/or 20 of the clamp circuit 10 to react.

At the end of the second phase ②, a difference between the supply voltage VDD at the input 12 and the voltage N1 at the first internal node 24 is sufficient to switch on the second trigger element 34 of the second control path 20, but still low enough not to flip the inverters 28 and 30. Accordingly, the voltage at node N2 stays high and the first trigger element 32 of the first control path 18 stays switched off. It is unlikely that the first control path 18 turns on, because assuming that the inverter voltage threshold is set to half of VDD, the supply voltage would need to double for the inverter chain to flip. In many cases, this would be too high. A possible solution would be to lower the switching voltage of the first inverter 28. However, this would come with the risk of unwished triggering at normal power-up. Also, if the first control path 18 is used during powered OV, the loop reaction time needs to be very fast to turn it off in time to prevent power brown-out.

Accordingly, at the beginning of a third phase ③, a second control current I2 flows through the second trigger element 34, gradually opening a discharge path through the protection device 16. Note that, compared with the situation depicted in Figure 2B, the maximum current IDS(MO) through the protection device 16 is lower than in the case of the ESD event. This is due to the fact that both the second trigger element 34 and the protection device 16 are controlled in an analog fashion in the OV event to prevent a sudden breakdown of the supply voltage VDD.

Once the externally provided (over-)voltage or charge is sunk by the clamping through the protection device, the supply voltage VDD will start to gradually drop, as shown in the later part of the third phase ③. This in turn leads to a gradual deactivation of the second trigger element 34 and a corresponding reduction of the second control current I2 to the control gate 22 of the protection device. Once the second trigger element 34 is deactivated completely, the gate voltage N3 will drop as the charge stored at the control gate 22 is discharged through the discharge element 36. This in turn reduces the discharge current IDS(MO) through the protection device as shown in Figure 3B. Please note that triggering the second control path 20 during powered OV allows to sink a current though M0 which is directly correlated with the OV level. This feature would not have been available if the first control path 18 were used instead, where the turn on/off speed would be of upmost importance to avoid circuit brown-out. Note also that the maximum ON-time of the protection device 16 is limited, as for an ESD event, by the RC time constant. The maximum ON-time acts are a safety mechanism to avoid causing thermal breakdown of the protection device 16 in case of long OV events. In that case an internal load circuit may therefore remain under stress and be damaged as would be if the clamp circuit 10 were not provided.

At the beginning of a last phase ④, when the voltage difference VDD-N1 drops below a given threshold voltage Vt2, the trigger element 34 turns off which in turn causes the protection device 16 to turn off completely again. For conventional chip designs, e.g. fabrication processes allowing a minimum MOSFET length of 130 to 180 nm, Vt2 may lie in the range of 0.6 to 0.8 V for a supply voltage of 1.5 to 1.8 V. For more recent fabrication processes, e.g., with a minimum allowed MOSFET length of 22 nm, Vt2 may lie near 0.4 V for a supply voltage of 0.8 V. Note that Vt2 may also be controlled at the design stage, for example, by adding appropriate implants to the used semiconductor material, to obtain a desired compromise between a low leakage current of the protection device 16 in the OFF-state, a low resistivity of the protection device 16 in the ON-state and/or a fast response time of the clamp circuit 10.

As a consequence, the control gate 22 is completely discharged via the discharge element 36. As soon as the gate voltage N3 drops below a minimum threshold voltage of the protection device 16, the protection device 16 blocks a discharge path and the supply voltage VDD returns to a steady state close to its nominal voltage.

Note that the first control path 18 uses a relatively strong trigger branch, which turns the first trigger element 32 completely on if an ESD event is detected by pulling the gate of the protection device 16 to the supply voltage VDD. In contrast, the second control path 20 is designed such that the protection device 16 brings the supply voltage VDD gradually back to a pre-stress voltage level, thereby preventing a resetting or damaging of an associated load.

As discussed above, the first control path 18 turns on when the absolute voltage on node N1 representing a low-pass filtered version of the supply voltage VDD is under a first threshold level Vt1 given by a fraction of the instantaneous VDD voltage, meaning N1 < Vt1 = *a* · VDD, where a is a constant. The absolute value of VDD is relevant as it defines the first threshold level Vt1. The second control path 20 turns on when VDD-N1 > Vt2 where Vt2 is a second threshold value given by the threshold voltage of the MOSFET M2, which is VDD independent. Typically, the first control path 18 is less likely to trigger under powered condition because the threshold value is high, while the second control path 20 will trigger with the same likelihood independently of the settled VDD voltage. Hence, the second control path 20 is more sensitive to voltage variation of the supply voltage VDD when the clamp circuit 10 and any internal load circuit is powered. At the same time, it provides a smaller second control current I2 for charging the control gate 22 of the protection device 16, which can be overcome more easily by the discharge current through the discharge element 36. In this way, the current response of the second control path 20 is more subtle than the current response of the first control path 18. Note that the design described above allows to limit the size of the second MOSFET M2, compared with a protection circuit comprising only the second control path 20. Such solution would require a relatively wide FET M2 to strongly drive the node N3 to protect reliably the load circuitry during an ESD event. The downside would be that any harmless disturbances on the supply would cause noticeable leakage through MOSFET M2, increasing in turn the control voltage on FET M0 and leakage thereof, which in many applications would not be acceptable. Moreover, MOSFET M2 may be triggered too easily at normal power up or due to a harmless voltage disturbance, which may accidentally trigger the protection device 16.

Note that the RC circuit 10 comprising the resistive element R1 and the capacitive element C1 correspond to a first time constant τ1 = R1 · C1. Moreover, the discharge path provided by the resistor R2, and a capacitance associated with the protection device 16, in particular the parasitic capacitance Cpar of the control gate 22 of the BigMOS FET M0, corresponds to a second associated time constant τ2 = R2 · Cpar. In other embodiments, a further capacitive element may be connected in parallel to the discharge element 36 and/or between the control gate 22 and drain terminal of the FET M0 to modify the capacitance as desired. τ2 is normally chosen to be much smaller than τ1 implying that the value of R2 has to be small and consequently M1 and M2 wide enough to deliver enough current when triggered to increase the voltage of node N3 above the threshold of FET M0.

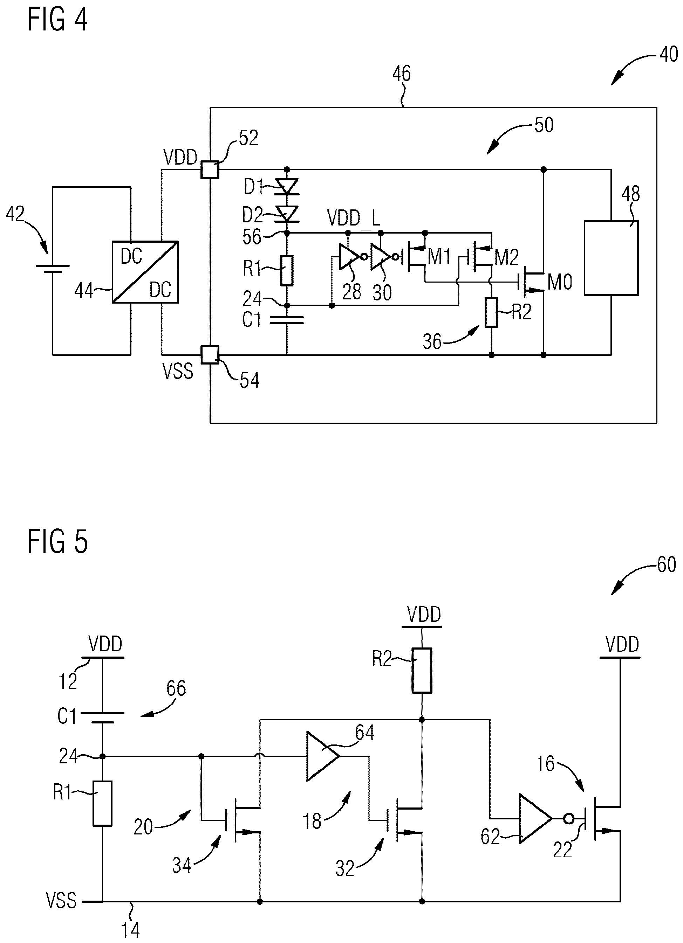

Figure 4 shows a communication device 40, such as a user equipment (UE) device of a mobile telecommunication network. Alternatively, the communication device 40 may also be another electrical device, such as a global satellite navigation systems (GNSS) receiver.

The communication device 40 comprises a power source 42, for example a rechargeable battery, a power supply circuit 44, in particular a DC/DC converter and an integrated circuit (IC) 46. In other configurations, the power source 42 such as an AC/DC adapter, may be external to the communication device and may be connected thereto by means of a plug connection or by inductive coupling.

The IC 46 may be a so-called system on a chip (SoC), and comprises an internal circuit 48, such as the core of a microcontroller performing some device-specific function. The IC 46 comprises an electrical protection circuit in the form of a second clamp circuit 50, a first pin 52 for connecting the IC 46 to a supply voltage VDD provided by the power supply circuit 44 and a second pin 54 for connecting the IC 46 to a reference potential VSS of the power supply circuit 44. As shown in Figure 4, the IC 46 is provided with the supply voltage VDD from the externally provided power supply circuit 44 via the pins 52 and 54. Alternatively, the power supply circuit 44 may form part of the IC 46. In this case, the pins 52 and 54 may be used to provide an external, potentially unregulated supply voltage to the power supply circuit 44. The chip internal circuit 48 is operated from the supply voltage VDD provided by the power supply circuit 44 via internal voltage rails and is protected against variations of the regulated supply voltage VDD by means of the clamp circuit 50 connected between the power supply circuit 44 and the internal circuit 48.

The second clamp circuit 50 has a similar design as the first clamp circuit 10 described with reference to Figures 1 to 3B. Accordingly, in the following, only the differences in its design are described.

Contrary to the situation depicted in Figure 1, the IC 46 makes use of a second, lower supply voltage VDD_L provided at a second internal node 56. In the described embodiment, respective voltage rails for the external supply voltage VDD and the second, internal supply voltage VDD_L are electrically connected by two diodes D1 and D2, which establish a predefined voltage difference between the first pin 52 and the second internal node 56. For example, an external supply voltage VDD of 5V may be converted to an internal supply voltage VDD_L of 3V. Instead of the diodes D1 and D2, controllable switches or current sources connected in series may be used to couple the supply voltages VDD and VDD_L.

Note that an operating voltage of the first and second inverters 28 and 30 are provided by the second internal node 56. Accordingly, the first trigger element 32 and the second trigger element 34 are triggered based on the voltage difference between the voltage VDD_L at second internal node 56 and the first internal node 24 rather than by a voltage difference between the supply voltage VDD and the first internal node 24 as previously described with reference to Figure 1. Otherwise, the operation and setup of the clamp circuit 50 corresponds to the setup and operation of the clamp circuit 10 as described before. While the clamp circuit 50 monitors only the internal supply voltage VDD_L, it clamps the external supply voltage VDD and thus effectively protects both current rails, and any further operating voltages derived therefrom.

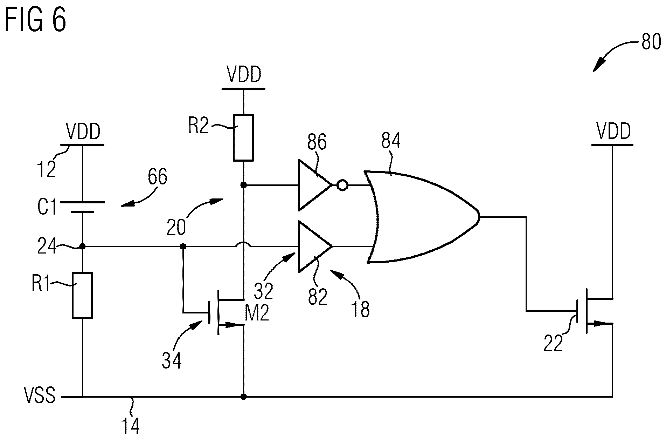

Figures 5 and 6 show two further electrical protection circuits in the form of clamp circuits 60 and 80 having a flipped filter or RC circuit design compared to the embodiments shown in Figures 1 and 4.

In particular, in the third clamp circuit 60 shown in Figure 5, an inverted RC circuit 66 comprises a capacitive element C1 connected between the supply voltage VDD and a first internal node 24 and a resistive element R1 connected between the first internal node 24 and the reference voltage VSS. Accordingly, the voltage at the first internal node 24 essentially follows the reference voltage VSS, and the respective control voltages provided through a first control path 18 and a second control path 20 must be inverted, too. Therefore, on the output side of the two trigger elements 32 and 34, an inverter 62 is provided to invert the output signal provided by the first control path 18 and the second control path 20, before providing the inverted control signal to the protection device 16. Note that the resistor R2 is also connected to the supply voltage VDD, to bring the input of the inverter 62 back to a high voltage level, thereby resetting the clamp circuit 60. The inverter 62 may be instantiated with CMOS logic gates or NMOS/PMOS-only logic gates using load resistors to maintain a correlation between the drawn current at FET M0 and the supply overvoltage amplitude.

Note that in the embodiment shown in Figure 5, the n-channel MOSFETS are used as first and second trigger elements 32 and 34. Moreover, in the first control path 18 of Figure 5, only a single buffer 64 is shown, which internally comprises an even number of inverters as described above with reference to Figure 1. The second control path 20 remains unchanged.

Figure 6 shows a possible implementation of a fourth clamp circuit 80, having a similar configuration with an inverted RC circuit 66 as detailed above with respect to Figure 5.

Again, the first control path 18 comprises an even number of inverters shown as a single buffer 82 configured to provide a digital output signal to a combinatorial element 84 in the form of an OR-gate. The voltage provided by the second control path 20 is input to an inverter 86, to perform the desired inversion of the control signal provided at the first internal node 24. The output of the OR-gate 84 is a digital signal. The protection device 16 is therefore always fully turned on and off. An OV event can be quenched without causing brown-out by designing the protection circuit 80 in such a way that the feedback loop from the supply through the resistor R2, the inverter 86, and the OR-gate 84 is fast enough to turn off the control gate 22 of the protection device 16 in time before the supply voltage VDD drops below a brown-out threshold voltage.

Note that the second control path 20 comprises a MOSFET M2 as first trigger element 34 as detailed before, and the inverter 86. The MOSFET M2 essentially digitized the control voltage provided at the first internal node 24 and provides a digital input control signal to the inverter 86. Note that the first control path 18 no longer comprises any MOSFETs and is implemented completely in the digital domain. Thus, in this embodiment, the buffer 82 itself acts as first trigger element 32. If at least one of the inputs to the combination element 84 is triggered by means of the first control path 18 or the second control path 20, the control gate 22 of the protection device 16 is pulled to the supply voltage VDD provided as operational voltage to the combinatorial element 84, thereby activating a discharge path therethrough. In an alternative embodiment, the buffer 82 may be omitted, and the first internal node 24 may be connected directly to a corresponding input of the OR-gate 84. In this case, a corresponding circuit part of the OR-gate 84 is digitizing the provided control signal directly and acts as first trigger element 32.

Note that the fourth clamp circuit 80 shown in Figure 6 works with fully digitized control signals from the buffer 82 and the inverter 86 onwards, such that the protection device is fully switched on in case one of the trigger elements 32 or 34 is triggered. Still, due to the gradual operation of the MOSFET M2 as a tunable current source and the provision of a discharge path via resistor R2, the second control path 20 still triggers based on absolute variation of the supply voltage VDD above a fixed threshold Vt2, while in the first control path 18 trigging happens if the supply voltage VDD increases rapidly above a supply voltage dependent threshold Vt1, making the first control path 18 ineffective for powered OV events.

### List of reference symbols

- 10: (first) clamp circuit
- 12: input
- 14: reference node
- 16: protection device
- 18: first control path
- 20: second control path
- 22: control gate (of the protection device)
- 24: first internal node
- 26: RC circuit
- 28: first inverter
- 30: second inverter
- 32: first trigger element
- 34: second trigger element
- 36: discharge element

- 40: communication device
- 42: power source
- 44: power supply circuit
- 46: IC
- 48: internal circuit
- 50: (second) clamp circuit
- 52: first pin
- 54: second pin
- 56: second internal node

- 60: (third) clamp circuit
- 62: inverter
- 64: buffer
- 66: inverted RC circuit

- 80: (fourth) clamp circuit
- 82: buffer
- 84: combinatorial element
- 86: inverter

- C1: capacitive element
- D1, D2: diode
- I1: first control current
- I2: second control current
- M0: (BigMOS) FET
- M1: (p-channel) MOSFET
- M2: (p-channel) MOSFET
- R1: resistive element
- R2: resistor
- VDD: (external) supply voltage
- VDD_L: (internal) supply voltage
- VSS: reference potential

## Claims

1. An electrical protection circuit, in particular an electrical clamp circuit (10, 50, 60, 80), comprising:
- a protection device (16) electrically coupled between a supply voltage (VDD) input (12) and a reference potential (VSS) and having a control gate (22) for selectively activating a discharge path;
- an RC circuit (26, 66), electrically coupled between the supply voltage (VDD) input (12) and the reference potential (VSS) and having a first internal node (24) for providing a control voltage;
- a first control path (18), electrically coupled between the first internal node (24) and the control gate (22) of the protection device (16) and having a first trigger element (32) for triggering the protection device (16), wherein the first trigger element (32) is configured to act as a digital control element, in particular as a switch; and
- a second control path (20), electrically coupled between the first internal node (24) and the control gate (22) of the protection device (16) and having a second trigger element (34) for triggering the protection device (16), wherein the second trigger element (34) is configured to act as a gradual control element, in particular as a tunable current source or resistor.

2. The electrical protection circuit of claim 1, wherein
- the first control path (18) is configured to have a first output current response to transient voltages at the supply voltage (VDD) input (12) for triggering the protection device (16) in case of an unpowered overvoltage, OV, event, in particular an electrostatic discharge, ESD, event; and
- the second control path (20) is configured to have a second output current response to transient voltages at the supply voltage (VDD) input (12) for triggering the protection device (16) in case of a powered OV event.

3. The electrical protection circuit of claim 1 or 2, wherein the first control path (18) comprises at least one inverter (28, 30) for providing a digital control signal to a control gate of the first trigger element (32).

4. The electrical protection circuit of claim 3, wherein the first trigger element (32) is a first enhancement-mode field effect transistor, FET, in particular a first p-channel MOSFET (M1), and the first control path (18) comprises an even number of inverters (28, 30) electrically coupled in series between the first internal node (24) and the control gate of the first FET.

5. The electrical protection circuit of any one of claims 1 to 4, wherein the second control path (20) is configured for providing an analog control signal to the second trigger element (34) by tracking a difference between an instantaneous supply voltage provided at the supply voltage (VDD) input (12) and a filtered supply voltage provided by the RC circuit (26, 66).

6. The electrical protection circuit of any one of claims 1 to 5, wherein the second control path (20) is configured to stop triggering the protection device (16) if a voltage difference between the supply voltage (VDD) input (12) and the first internal node (24) drops below a predefined threshold voltage.

7. The electrical protection circuit of any one of claims 1 to 6, wherein the second trigger element (34) is a second enhancement-mode field effect transistor, FET, in particular a second p-channel MOSFET (M2), and the first internal node (24) is electrically directly connected to a control gate of the second FET.

8. The electrical protection circuit of any one of claims 1 to 7, further comprising a discharge element (36), in particular a resistor (R2) or a FET element with a dynamically driven gate, electrically coupled to the control gate (22) of the protection device (16) for discharging the control gate (22) of the protection device (16) in case both the first control path (18) and the second control path (20) are disabled.

9. The electrical protection circuit of claim 8, wherein a first time constant defined by the RC circuit (26, 66) is larger than a second time constant defined by the discharge element (36) and a capacitive element associated with the protection device (16), in particular a parasitic capacitance of the control gate (22) of the protection device (16).

10. The electrical protection circuit of any one of claims 1 to 9, further comprising a combinatorial element (84), in particular a logical OR-gate, a first input of the combinatorial element (84) being electrically coupled to the first trigger element (32), a second input of the combinatorial element (84) being electrically coupled to the second trigger element (34), and an output of the combinatorial element (84) being electrically coupled to the control gate (22) of the protection device (16).

11. The electrical protection circuit of any one of claims 1 to 10, wherein the RC circuit (26) comprises a resistive element (R1) electrically coupled between the supply voltage (VDD) input (12) and the first internal node (24), and a capacitive element (C1) electrically coupled between the first internal node (24) and the reference voltage potential (VSS).

12. The electrical protection circuit of any one of claims 1 to 10, wherein the RC circuit (66) comprises a capacitive element (C1) electrically coupled between the supply voltage (VDD) input (12) and the first internal node (24), and a resistive element (R1) electrically coupled between the first internal node (24) and the reference voltage potential (VSS).

13. The electrical protection circuit of any one of claims 11 or 12, further comprising a second internal node (56) electrically coupled to the supply voltage (VDD) input (12) by means of one or more diodes (D1, D2), switches and/or current sources for providing a second supply voltage (VDD_L) monitored by the RC circuit (26, 66), wherein a supply voltage input of at least one of the first trigger element (32) and the second trigger element (20) is electrically coupled to the second supply voltage (VDD_L).

14. An integrated circuit, IC (46), in particular a system on a chip, SoC, comprising:
- a first voltage rail for providing a supply voltage (VDD);
- a second voltage rail for providing a reference voltage (VSS);
- an internal circuit (48) configured to be supplied by the supply voltage (VDD); and
- an electrical protection circuit according to any one of claims 1 to 13, the electrical protection circuit being electrically coupled between the first voltage rail and the second voltage rail and configured to protect the internal circuit (48) from both an unpowered overvoltage, OV, event, in particular an electrostatic discharge, ESD, event, and a powered OV event.

15. A mobile communication device (40), in particular a user equipment, UE, or global navigation satellite systems, GNSS, device, comprising:
- the integrated circuit (46) according to claim 14; and
- a power supply circuit (44), in particular a DC/DC converter circuit, wherein output terminals of the power supply circuit (44) are electrically coupled to the first voltage rail and the second voltage rail of the integrated circuit (46).
